Europäisches Patentamt

European Patent Office

Office européen des brevets

(19)

(11) Veröffentlichungsnummer: **0 430 187 A2**

## (12) EUROPÄISCHE PATENTANMELDUNG

(21) Anmeldenummer: 90122682.9

(22) Anmeldetag: 27.11.90

(51) Int. Cl.5: **H03K 19/017**, H03K 19/0948

(30) Priorität: 30.11.89 DE 3939637

(43) Veröffentlichungstag der Anmeldung:
05.06.91 Patentblatt 91/23

(84) Benannte Vertragsstaaten:
DE FR GB IT NL Patentblatt 00/1

(71) Anmelder: **Siemens Aktiengesellschaft**
**Wittelsbacherplatz 2**
**W-8000 München 2(DE)**

(72) Erfinder: **Barré, Claude, Dipl.-Ing.**
**Implerstrasse 23**
**W-8000 München 70(DE)**

(54) **Digitalschaltung mit Schaltstufen nach Art der komplementären MOS-Schaltungstechnik.**

(57) Schaltstufen nach Art der komplementären MOS-Schaltungstechnik weisen zwei Schaltstrecken auf, die umschaltbar gegenphasig einen geschlossenen bzw. geöffneten Zustand einnehmen. Jedem Schaltstufeneingang ist in einer ersten Schaltstrecke (P1) ein PMOS- und in einer zweiten Schaltstrecke (N1) ein NMOS-Feldeffekttransistor als Schaltelement zugeordnet. Die Ausgänge (A11, A21) der Schaltstrecken (P1, N1) sind über ein, wenigstens während eines Umschaltvorganges eine Spannungsdifferenz bewirkendes Bauelement (R) verbunden. Der Ausgang (A11) der ersten Schaltstrecke (P1) ist an eine erste, der Ausgang (A21) der zweiten Schaltstrecke (N1) an eine zweite Signalleitung (L1; L2) zum Anschluß an nachfolgende Schaltstufen angeschlossen. Zur Reduzierung eines bei einem Umschaltvorgang durch beide Schaltstrecken (P2, N2) einer nachfolgenden Schaltstufe fließenden Umschaltstromes ist die erste Signalleitung (L1) an die Gateelektrode Ges dem Schaltstufeneingang der nachfolgenden Schaltstufe zugeordneten PMOS- und die zweite Signalleitung (L2) an die Gateelektrode des zugeordneten NMOS-Feldeffekttransistors (TP, TN) angeschlossen. Zur Beschleunigung des Umschaltvorganges bei einer nachfolgenden Schaltstufe ist die erste Signalleitung (L1) an die Gateelektrode des dem Schaltstufeneingang der nachfolgenden Schaltstufe zugeordneten NMOS- und die zweite Signalleitung (L2) an die Gateelektrode des zugeordneten PMOS-Feldeffekttransistors (TN, TP) angeschlossen.

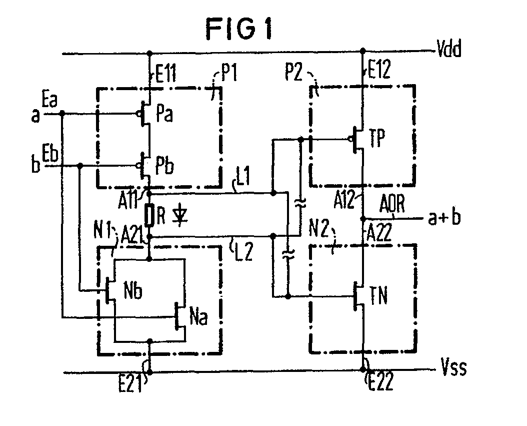

FIG 1

Xerox Copy Centre

EP 0 430 187 A2

# DIGITALSCHALTUNG MIT SCHALTSTUFEN NACH ART DER KOMPLEMENTÄREN MOS-SCHALTUNGSTECHNIK

Die Erfindung betrifft digitale Schaltungen mit Schaltstufen nach Art der komplementären MOS-Schaltungstechnik gemäß dem Oberbegriff des Patentanspruchs 1 bzw. des Patentanspruchs 2.

Durch ihren geringen Flächen- und Leistungsbedarf sowie ihre vergleichsweise leichte Integrierbarkeit bieten Feldeffekttransistoren für hochintegrierte Schaltungen entscheidende Vorzüge. In der Digitaltechnik kann mit Feldeffekttransistoren ein einfacher Schaltungsaufbau und eine große Störsicherheit erreicht werden. Außerdem läßt sich mit Feldeffekttransistoren die Verlustleistung digitaler Schaltungen äußerst niedrig halten, wie insbesondere von in komplementärer MOS-Schaltungstechnik aufgebauten digitalen Schaltstufen bekannt ist.

Die komplementäre MOS-Schaltungstechnik, auch CMOS-Schaltungstechnik genannt, beruht vom Grundprinzip her auf einer Inverterstufe, bestehend aus einer zwei Spannungspotentiale verbindenden Reihenschaltung eines selbstsperrenden P-Kanal- (PMOS) und eines selbstsperrenden N-Kanal- (NMOS) Feldeffekttransistors, deren Gateelektroden miteinander verbunden sind und einen Schaltstufeneingang für ein digitales Eingangssignal bilden. Als Schaltstufenausgang dient ein Mittelabgriff der Reihenschaltung.

Im statischen Zustand des digitalen Eingangssignals ist jeweils genau einer der beiden Feldeffekttransistoren leitend, weshalb kein Stromfluß zwischen den beiden Spannungspotentialen auftreten kann, und damit keine Verlustleistung entsteht.

Bei einem Pegelwechsels des digitalen Eingangssignales sind jedoch beide Feldeffekttransistoren für eine gewisse Umschaltzeit leitend, während der ein Umschaltstrom über beide Feldeffekttransistoren fließen kann.

Gattungsgemäße Digitalschaltungen sind beispielsweise aus der DE-OS 31 48 410 und der DE-OS 38 37 080 bekannt. Die erste Druckschrift hat parallel bzw. in Serie zu den Schaltstrecken einer Schaltstufe noch programmierbare Elemente, die bewirken, daß die Anordnung als NAND-Glied mit 2 oder 3 wirksamen Eingängen oder als Inverter betrieben werden kann. Beim Umschalten verbrauchen die CMOS-Paare Leistung durch den Querstrom. Die zweite Druckschrift beschreibt die Reihenschaltung konventioneller Schaltstufen.

Durch Dimensionierung der Feldeffekttransistoren bezüglich ihres Innenwiderstandes läßt sich - bei geringem Innenwiderstand - die Umschaltzeit auf Kosten eines höheren Umschaltstromes verkürzen bzw. - bei großem Innenwiderstand - der Umschaltstrom auf Kosten einer längeren Umschaltzeit verringern. Für die Dimensionierung der Feldeffekttransistoren muß daher ein Kompromiß zwischen Umschaltzeit und Umschaltstrom gefunden werden. Da beim Herstellungsprozeß einer integrierten Schaltung die Dimensionierung der Feldeffekttransistoren festgelegt wird, ist danach eine Korrektur des Kompromisses zwischen Umschaltzeit und Umschaltstrom nicht mehr möglich.

Aufgabe der vorliegenden Erfindung ist es daher, Digitalschaltungen mit Schaltstufen nach Art der CMOS-Schaltungstechnik so weiterzubilden, daß die Schaltstufen gegenüber anderen Schaltstufen mit gleicher Transistordimensionierung einen verringerbaren Umschaltstrom bzw. eine verringerbare Umschaltzeit aufweisen.

Gelöst wird die Aufgabe erfindungsgemäß durch die kennzeichnen-den Merkmale des Patentanspruchs 1 bzw. des Patentanspruchs 2. Ist der Ausgang der ersten Schaltstrecke mit dem, einem betreffenden Schaltstufeneingang einer nachfolgenden Schaltstufe zugeordneten PMOS-FET und der Ausgang der zweiten Schaltstrecke mit dem entsprechenden zugeordneten NMOS-FET der nachfolgenden Schaltstufe verbunden, so verringern sich die Gate-Source-Spannungen an dem PMOS- und an dem NMOS-FET der zweiten Schaltstufeum jeweils den halben Betrag des Spannungswertes, der an dem eine Spannungsdifferenz bewirkenden Bauelement entsteht. Die Verringerung der Gate-Source-Spannungen führt damit zu einer Reduzierung des bei einem Umschaltvorgang durch beide Schalt strecken der nachfolgenden Schaltstufe fliessenden Umschaltstromes.

Ist der Ausgang der ersten Schaltstrecke mit dem, einem betreffenden Schaltstufeneingang einer nachfolgenden Schaltstufe zugeordneten NMOS-FET und der Ausgang der zweiten Schaltstrecke mit dem entsprechend zugeordneten PMOS-FET einer nachfolgenden Schaltstufe verbunden, so erhöhen sich die Gate-Source-Spannungen an dem PMOS- und NMOS-FET der zweiten Schaltstufe um jeweils den halben Betrag des Spannungswertes, der an dem eine Spannungsdifferenz bewirkenden Bauelement entsteht. Die Erhöhung der Gate-Source-Spannung führt zu einer Erhöhung des bei einem Umschaltvorgang durch beide Schaltstrecken der nachfolgenden Schaltstufe fließenden Umschaltstromes und damit zu einer Beschleunigung des Umschaltvorganges der nachfolgenden Schaltstufe.

Ein wesentlicher Vorteil einer erfindungsgemäß ausgebildeten Digitalschaltung besteht darin, daß der Umschaltstrom bzw. die Umschaltzeit durch den charakteristischen Wert eines einzigen Bauelementes in weiten Grenzen verendet werden kann, ohne daß dafür Transistoren umdimensioniert werden müssen.

Vorteilhafte Weiterbildungen der Erfindung sind in den Unteransprüchen angegeben.

Anhand der Zeichnung werden im folgenden zwei Ausführungsbeispiele näher erläutert.

Dabei zeigen

FIG 1    ein Schaltbild für eine Digitalschaltung aus zwei zu einer logischen ODER-Verknüpfungsschaltung verbundenen Schaltstufen mit verringertem Umschaltstrom

FIG 2    ein Schaltbild für eine Digitalschaltung aus zwei zu einer logischen ODER-Verknüpfungsschaltung verbundenen Schaltstufen mit verringerter Umschaltzeit.

In der FIG 1 sowie in der FIG 2, ist jeweils ein Stromlaufplan für eine logische ODER-Verknüpfungsschaltung dargestellt, die im wesentlichen nach den Prinzipien der komplementären MOS-Schaltungstechnik (im folgenden auch CMOS-Schaltungstechnik genannt) konzipiert ist.

Diese ODER-Verknüfungsschaltung setzt sich aus einer, eine NICHT-ODER-Verknüpfung bewirkenden ersten Schaltstufe (auf der linken Seite der Figuren) und einer dieser nachgeschalteten, einen Negator bildenden zweiten Schaltstufe (in den Figuren rechts) zusammen.

Beide Schaltstufen bestehen jeweils aus einer ersten und einer zweiten Schaltstrecke P1, N1; P2, N2 mit PMOS- bzw. NMOS-Feldeffekttransistoren (im folgenden auch PMOS-FET's bzw . NMOS-FET's genannt) als Schaltelemente.

Die erste Schaltstrecke P1 der ersten Schaltstufe besteht aus zwei in Serie geschaltete PMOS-Feldeffekttransistoren Pa, Pb; die zweite Schaltstrecke N1 aus zwei parallelgeschalteten NMOS-Feldeffekttransistoren Na, Nb. Die beiden Schaltstrecken P1, N1 sind an ihren Ausgängen A11, A21 über einen Widerstand R miteinander verbunden und an ihren Eingängen E11, E21 an ein erstes, bzw. an ein zweites Spannungspotential Vdd; Vss angeschlossen, wobei das erste Spannungspotential Vdd gegenüber dem zweiten Spannungspotential Vss auf einem positiveren Spannungspotential liegt.

Auch die beiden Schaltstrecken P2, N2 der zweiten Schaltstufe, die jeweils einen einzigen PMOS-FET bzw. NMOS-FET TP, TN aufweisen, sind an ihren Eingängen E12, E22 an das erste bzw. zweite Spannungspotential Vdd; Vss angeschlossen. An ihren Ausgängen A12, A22 sind diese beiden Schaltstrecken P2, N2, wie in der CMOS-Technik üblich, direkt miteinander verbunden und bilden den Schaltstufenausgang der zweiten Schaltstufe und damit zugleich den Ausgang AOR der ODER-Verknüpfungsschaltung.

Sämtliche Feldeffekttransistoren in den Schaltstrecken sind lediglich mit ihrer Drain-Source-Strecke an der Bildung der Schaltstrecken beteiligt. Die Drainelektroden der Feldeffekttransistoren sind dabei stets dem Ausgang der jeweiligen Schaltstrecke zugewandt.

Als Eingänge Ea, Eb der ersten Schaltstufe und damit der ODER-Verknüpfungsschaltung dienen die Gateelektroden der zur ersten Schaltstufe gehörenden PMOS- bzw. NMOS-FET's PA, PB; NB, NA, wobei, wie in der CMOS-Technik üblich, jedem der PMOS-FET's PA, PB genau ein NMOS-FET Na, Nb logisch zugeordnet ist und die Gateelektroden der einander zugeordneten FET's miteinander verbunden sind und jeweils einen Eingang Ea, Eb für ein digitales Eingangssignal a, b bilden.

Die digitalen Eingangssignale a, b können die beiden binären Werte "0", "1" einnehmen, die durch die Spannungswerte der beiden Spannungspotentiale Vdd, Vss repräsentiert werden. Bei positiver Logik ist dem binären "1"-Wert der Spannungswert des ersten und dem binären "0"-Wert der des zweiten Spannungspotentials Vss zugeordnet.

Bei der zweiten Schaltstufe sind die Gateelektroden der logisch einander zugeordneten PMOS- und NMOS-FET's TP, TN nicht miteinander verbunden, sondern voneinander getrennt über eine jeweilige Signalleitung L1, L2 an jeweils einen Schaltstreckenausgang A11, A21 der ersten Schaltstufe angeschlossen.

Wie in dem Stromlaufplan der ODER-Verknüpfungsschaltung nach FIG 1 dargestellt ist, ist der Ausgang A11 der ersten Schaltstrecke P1 der ersten Schaltstufe über eine Signalleitung L1 mit der Gateelektrode des PMOS-FET'S TP der zweiten Schaltstufe verbunden, der Ausgang A21 der zweiten Schaltstrecke N1 ist in analoger Weise über die Signalleitung L2 an die Gateelektrode des NMOS-FET's TN angeschlossen.

Im Gegensatz dazu ist bei der ODER-Verknüpfungsschaltung nach FIG 1 der Ausgang A1 der ersten Schaltstrecke P1 an die Gateelektrode des NMOS-FET's TN, und der Ausgang A2 der zweiten Schaltstrecke N1 an die Gateelektrode des PMOS-FET's TP angeschlossen.

Im stationären Zustand (d.h. während des Betrachtungszeitraumes tritt kein Wechsel der Werte an den Eingängen EA, EB auf, der zu einem Umschaltvorgang der Schaltstrecken führt) verhalten sich die beiden ODER-Verknüpfungsschaltungen nach FIG 1 und FIG 2 gleich.

Durch den Widerstand R der ersten Schaltstufe fließt im stationären Zustand kein Strom, da nur jeweils eine der Schaltstrekken P1, N1 leitend ist. Damit tritt über dem Widerstand R auch kein Spannungsabfall auf, und die Spannungswerte an den beiden Schaltstreckenausgängen A11, A21 und damit an den mit diesen verbundenen Gateelektroden der FET's TP, TN der zweiten Schaltstufe sind zueinander gleich. Die Spannungswerte entsprechen je nach Schaltzustand der ersten Schaltstufe entweder dem Wert des ersten oder dem des zweiten Spannungspotentials Vdd, Vss.

Demzufolge verhalten sich solche, nach der Erfindung ausgebildeten Digitalschaltungen im stationären Zustand wie äquivalente, in herkömmlicher CMOS-Technik realisierte Schaltungen.

Der wesentliche Unterschied und damit auch die Vorteile von gemäß der Erfindung ausgebildeten Digitalschaltungen gegenüber herkömmlichen CMOS-Schaltungen werden erst bei Betrachtung des dynamischen Verhaltens, also während eines Umschaltvorganges deutlich. Als der für eine Erläuterung interessanteste Zeitpunkt bei einem Umschaltvorgang bietet sich der Moment an, an dem das einen Umschaltvorgang auslösende digitale Eingangssignal a, b während eines Wertewechsels einen genau in der Mitte zwischen dem ersten und dem zweiten Spannungspotential Vdd, Vss liegenden Spannungsmittelwert einnimmt.

Beim vorliegenden Beispiel der ODER-Verknüpfungsschaltung nach FIG 1 und FIG 2 führt dieser Spannungsmittelwert z.B. am ersten Eingang EA (der zweite Eingang EB wird zur Vereinfachung als mit dem zweiten Spannungspotential Vss, d.h. mit einem binären "0"-Wert beaufschlagt angenommen) dazu, daß die Gate-Source-spannungen an dem, den Eingang EA zugeordneten FET PA und NMOS-FET NA der ersten Schaltstufe auch den Betrag des Spannungsmittelwertes aufweisen. Bekanntlich ist der Innenwiderstand eines FET's umso geringer, je größer seine Gate-Source-spannung ist.

Da zudem der dem zweiten Eingang EB zugeordnete PMOS-FET PB leitet und der zugehörige NMOS-FET NB sperrt, weisen beide Schaltstrecken P1, N1 der ersten Schaltstufe den gleichen Widerstand auf. Über den Widerstand R fließt ein Umschaltstrom vom ersten zum zweiten Spannungspotential Vdd, Vss.

Damit weist der Ausgang A11 der ersten Schaltstrecke P1 einen positiveren Spannungswert auf als der Ausgang A21 der zweiten Schaltstrecke N1. Die Differenz dieser Spannungswerte entspricht dem Spannungsabfall über den Widerstand R.

Bei der ODER-Verknüpfungsschaltung nach FIG 1 ist damit auch die Gate-Sourcespannung an dem PMOS-FET TP und die an dem NMOS-FET TN der zweiten Schaltstufe geringer als der Spannungsmittelwert, der sich bei herkömmlicher CMOS-Technik einstellen würde.

Deshalb sind bei der erfindungsgemäß ausgebildeten Digitalschaltung die Innenwiderstände beider FET's TP, TN der zweiten Schaltstufe größer und der Umschaltstrom in der zweiten Schaltstufe ist folglich geringer.

Bei der ODER-Verknüpfungsschaltung nach FIG 2 sind jedoch die Gate-Source-Spannungen an beiden FET's TP, TN der zweiten Schaltstufe größer als der Spannungsmittelwert, wodurch sich der Umschaltstrom in der zweiten Schaltstufe erhöht und zu einer Beschleunigung des Umschaltvorganges führt.

Der ohmsche Widerstand R in der ersten Schaltstufe kann auch durch eine in Flußrichtung gepolte Diode ersetzt werden. Zudem kann es in einer integrierten Schaltung vorteilhaft sein, beide Ausgänge A11, A21 der beiden Schaltstrecken P1, N1 der ersten Schaltstufe über eine eigene Signalleitung an beide FET's TP, TN der zweiten Schaltstufe zu führen, um später, je nach Bedarf, diesen Zustand zu belassen (entspricht dann der herkömmlichen CMOS-Technik), oder aber durch Unterbrechung der in Frage kommenden Signalleitungen entweder den Umschaltstrom zu verringern oder die Umschaltzeit zu reduzieren. Unterschiedliche Transistordimensionierungen auf einer integrierten Schaltung können somit vermeidbar gemacht werden.

## Ansprüche

1. Digitalschaltung mit Schaltstufen nach Art der komplementären MOS-Schaltungstechnik, bestehend aus jeweils einer ersten und einer zweiten, an ihren Ausgängen miteinander verbundenen Schaltstrecken, die umschaltbar gegenphasig einen geschlossenen bzw. geöffneten Zustand einnehmen und zur alternativen Zuführung eines ersten bzw. zweiten Spannungspotentials an einen Schaltstufenausgang dienen und die jedem Schaltstufeneingang zugeordnet als Schaltelement in der ersten Schaltstrecke je einen PMOS- bzw. in der zweiten Schaltstrecke je einen NMOS-Feldeffekttransistor aufweisen, deren Gateelektroden als Anschluß des jeweiligen Schaltstufeneingangs dienen,
dadurch gekennzeichnet, daß die Ausgänge (A11, A21) der Schaltstrecken (P1,N1) über ein wenigstens während eines Umschaltvorgangs eine Spannungsdifferenz zwischen den Ausgängen (A11,A21) bewirkendes Bauelement verbunden sind, daß der Ausgang (A11) der ersten Schaltstrecke (P1) mit einer ersten und der Ausgang (A21) der zweiten Schaltstrecke (N1) mit einer zweiten Signalleitung (L1;L2) zum Anschluß an nachfolgende Schaltstufen verbunden ist und daß der Schaltstufenausgang mit einem betreffenden Schaltstufeneingang der nachfolgenden Schaltstufe in der Weise verbunden ist, daß die erste Signalleitung (L1) an die Gateelektrode des dem Schaltstufeneingang zugeordneten PMOS-Feldeffekttransistors (TP) und die zweite Signalleitung (L2) an die Gateelektrode des dem Schaltstufeneingang zugeordneten NMOS-Feldeffekttransistors (TN) angeschlossen ist.

2. Digitalschaltung mit Schaltstufen nach Art der komplementären MOS-Schaltungstechnik, bestehend aus jeweils einer ersten und einer zweiten, an ihren Ausgängen miteinander verbundenen Schaltstrecken, die umschaltbar gegenphasig einen geschlossenen bzw. geöffneten Zustand einnehmen und zur alternativen Zuführung eines ersten bzw. zweiten Spannungspotentials an einen Schaltausgang dienen und die jedem Schaltstufeneingang zugeordnet als Schaltelement in der ersten Schaltstufe je einen PMOS- bzw. in der zweiten Schaltstufe je einen NMOS-Feldeffekttransistor aufweisen, deren Gateelektroden als Anschluß des jeweiligen Schaltstufeneingangs dienen, **dadurch gekennzeichnet,** daß die Ausgänge (A11,A21) der Schaltstrecken (P1,N1) über ein, wenigstens während eines Umschaltvorgangs eine Spannungsdifferenz zwischen den Ausgängen (A11,A21) bewirkendes Bauelement verbunden sind, daß der Ausgang (A11) der ersten Schaltstrecke (P1) mit einer ersten und der Ausgang (A21) der zweiten Schaltstrecke (N1) mit einer zweiten Signalleitung (L1;L2) zum Anschluß an nachfolgende Schaltstufen verbunden ist und daß der Schaltstufenausgang mit einem betreffenden Schaltstufeneingang der nachfolgenden Schaltstufe in der Weise verbunden ist, daß die erste Signalleitung (L1) an die Gateelektrode des dem Schaltstufeneingang zugeordneten NMOS-Feldeffekttransistors (TN) und die zweite Signalleitung (L2) an die Gateelektrode des dem Schaltstufeneingang zugeordneten PMOS-Feldeffekttransistors (TP) angeschlossen ist.

3. Digitalschaltung nach Anspruch 1 oder 2, **dadurch gekennzeichnet,** daß die erste bzw. zweite Signalleitung (L1; L2) zum wahlweisen Anschluß an die Gateelektrode des PMOS- oder die des NMOS-Feldeffekttransistors über je ein unterbrechbares Leiterstück mit beiden Gateelektroden verbunden ist.

4. Digitalschaltung nach einem der vorhergehenden Ansprüche, **dadurch gekennzeichnet,** daß das die Spannungsdifferenz bewirkende Bauelement ein Widerstand ist.

5. Digitalschaltung nach einem der Ansprüche 1 bis 3,

**dadurch gekennzeichnet,** daß das die Spannungsdifferenz bewirkende Bauelement eine in Flußrichtung gepolte Diode ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 9, Nr. 123 (E-317)[1846], 28. Mai 1985; & JP-A-60 10 920 (MITSUBISHI DENKI) 21-01-1985 * Ganzes Dokument * | 1,4,5 | H 03 K 19/017 H 03 K 19/0948 |
| Y | IDEM | 2,3 | |
| Y | US-A-4 649 295 (McLAUGHLIN et al.) * Figur 1; Zusammenfassung; Spalte 3, Zeilen 49-55 * | 2 | |
| Y | US-A-4 124 899 (BIRKNER et al.) * Figur 2; Spalte 4, Zeilen 1-11 * | 3 | |
| A | PATENT ABSTRACTS OF JAPAN, Band 11, Nr. 306 (E-546)[2753], 6. Oktober 1987; & JP-A-62 98 825 (SEIKO EPSON) 08-05-1987 * Ganzes Dokument * | 1,5 | |
| | | | **RECHERCHIERTE SACHGEBIETE (Int. Cl.5)** H 03 K |

Der vorliegende Recherchenbericht wurde für alle Patentansprüche erstellt

| Recherchenort | Abschlußdatum der Recherche | Prüfer |
|---|---|---|
| DEN HAAG | 25-03-1991 | JEPSEN J. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes
    Dokument

EPO FORM 1503 03.82 (P0403)